# EUROPÄISCHE PATENTANMELDUNG

(11) **EP 2 371 512 A1**
(43) Veröffentlichungstag der Anmeldung: **05.10.2011**
(21) Anmeldenummer: 10158912.5
(22) Anmeldetag: 01.04.2010
(51) Int. Cl.: B29C 45/16, B01L 3/00, B81C 1/00

(54) **Verfahren zur Erzeugung eines lichten Zwischenraums zwischen einem ersten und einem zweiten Element**

(71) Anmelder: BOEHRINGER INGELHEIM microParts GmbH, 44227 Dortmund (DE)
(72) Erfinder: Rodenfels, Tobias, 55216 Ingelheim am Rhein (DE)
(74) Vertreter: Hammann, Heinz

(57) **Zusammenfassung**

Die Erfindung betrifft ein Verfahren zur Erzeugung eines zumindest bereichsweise lichten Zwischenraums (A) zwischen wenigstens einem ersten Element (26) und wenigstens einem zweiten Element (27) eines mikrofluidischen Bauteils (25).

Bei dem Verfahren sind die Werkstoffe der Elemente (26,27) zumindest hinsichtlich einer ihrer Eigenschaften unterschiedlich, wobei in einem ersten Verfahrensschritt das erste Element (26) hergestellt und in einem zweiten Verfahrensschritt der Werkstoff des zweiten Elementes (27) dem ersten Element (26) zugeführt wird und wobei in einem dritten Verfahrensschritt das zweite Element (27) zumindest bereichsweise einer Volumenverringerung unterzogen wird, derart, dass der zumindest bereichsweise lichte Zwischenraum (A) entsteht.

Dadurch wird ein Verfahren bereitgestellt, bei dem mit vergleichsweise geringem Aufwand zumindest ein Teil einer Mikrostruktur (Mikrospalt, Mikrokanal, Mikrokavität, etc.) herstellbar ist.

Die Erfindung betrifft auch ein mikrofluidisches Bauteil (25), welches aufgrund seiner Ausgestaltung besonders gut mit dem erfindungsgemäßen Verfahren herstellbar ist.

## Beschreibung

Die Erfindung betrifft ein Verfahren zur Erzeugung eines zumindest bereichsweise lichten Zwischenraums zwischen wenigstens einem ersten Element und wenigstens einem zweiten Element eines mikrofluidischen Bauteils. Die Erfindung betrifft ferner auch ein mikrofluidisches Bauteil, welches nach dem Verfahren herstellbar ist.

In vielen Anwendungsgebieten der Technik werden mikrofluidische Bauteile eingesetzt, so z. B. bei der Zerstäubung von Flüssigkeiten (Respiratoren, Druckköpfe von Tintenstrahldruckern, etc.) oder auch in der biotechnologischen Messtechnik (beispielsweise Biosensoren zur Analyse von biologischen Proben, wie Blut, Urin etc.). Das mikrofluidische Bauteil muss daher zumindest bereichsweise eine entsprechende Mikrostruktur aufweisen, die zur Aufnahme, Speicherung und/oder auch Weiterleitung von Fluiden geeignet ist. Beispielsweise kann es sich bei der Mikrostruktur um einen Kanal, ein Reservoir, eine Kavität oder auch einen Spalt handeln.

Seit vielen Jahren wird zur Herstellung von mikrofluidischen Bauteilen (Mikrostrukturen) unter anderem das Spritzgießen mit hoher Zuverlässigkeit eingesetzt. Dabei können Formteile mit Mikrostrukturen erzeugt werden, welche Dimensionen in Mikrometerbereichen aufweisen. Zur Abformung solcher Mikrostrukturen ist ein erheblicher technischer Aufwand erforderlich. Insbesondere muss gewährleistet werden, dass die Werkzeuge und mikrostrukturierten Formeinsätze vollständig vom Kunststoff ausgefüllt werden und dass beim Befüllen keine Beschädigung der Formeinsätze stattfindet.

Mit abnehmender Strukturgröße steigt der Aufwand unverhältnismäßig groß an, insbesondere sind mit dem herkömmlichen Spritzgussverfahren und den Abformtechniken der Herstellung von Mikrostrukturen mit größeren Aspektverhältnissen Grenzen gesetzt. Unter Aspektverhältnis wird dabei das Verhältnis von Höhe zur Breite einer Mikrostruktur (beispielsweise eines Mikrokanals) verstanden. Bei herkömmlicher Herstellungsweise können Aspektverhältnisse in einer Größe von etwa 3 bis 5 relativ unproblematisch erzielt werden. Es können jedoch Anwendungsfälle auftreten, wo erheblich größere Aspektverhältnisse gewünscht bzw. erforderlich sind.

Aus der DE 197 05 303 A1 ist ein Verfahren zur Herstellung von Klein- und Mikroteilen aus einer Formmasse mit Hilfe von Formwerkzeugen bekannt. Zur Reduzierung der Zykluszeiten bei der Abformung der Mikrostrukturen wird eine Formmasse verwendet, welche mindestens eine durch kurzwelliges Licht härtbare Komponente enthält, wobei nach der Formgebung der Formasse die Aushärtung durch die Bestrahlung mit kurzwelligem Licht im Formwerkzeug erfolgt.

Der Erfindung liegt daher die Aufgabe zugrunde, ein Verfahren bereitzustellen, bei dem mit vergleichsweise geringem Aufwand zumindest ein Teil einer Mikrostruktur (Mikrospalt, Mikrokanal, Mikrokavität, etc.) herstellbar ist.

Diese Aufgabe wird erfindungsgemäß mit einem Verfahren gemäß Patentanspruch 1 gelöst. Die Unteransprüche betreffen vorteilhafte Weiterbildungen der Erfindung.

Erfindungsgemäß ist ein Verfahren zur Erzeugung eines zumindest bereichsweise lichten Zwischenraums zwischen wenigstens einem ersten Element und wenigstens einem zweiten Element eines mikrofluidischen Bauteils vorgesehen, wobei die Werkstoffe der Elemente zumindest hinsichtlich einer ihrer Eigenschaften unterschiedlich sind, wobei in einem ersten Verfahrensschritt das erste Element hergestellt und in einem zweiten Verfahrensschritt der Werkstoff des zweiten Elementes dem ersten Element zugeführt wird und wobei in einem dritten Verfahrensschritt das zweite Element zumindest bereichsweise einer Volumenverringerung unterzogen wird, derart, dass der zumindest bereichsweise lichte Zwischenraum entsteht.

Es wird somit also gezielt bzw. bewusst die Unterschiedlichkeit einer Werkstoffeigenschaft zweier zur Herstellung des mikrofluidischen Bauteils verwendeter Elemente eingesetzt, um durch gezielt gesteuerte Volumenverringerung einen lichten Zwischenraum entstehen zu lassen. Vorzugsweise erfolgt dabei die Volumenverringerung des zweiten Elementes bzw. seines Werkstoffes durch Schwindung, ohne dass dabei also Material bzw. Werkstoff entfernt wird. Der erzeugte lichte Zwischenraum kann dann beispielsweise ein Mikrokanal, ein Mikrospalt, eine Mikrokavität oder dergleichen sein. Der Vorteil ist, dass dieser lichte Zwischenraum selbst ohne eine vorherige Abformung in diesem Bereich (wie sie beim herkömmlichen Herstellungsverfahren notwendig ist) erhalten werden kann. Zudem sind sehr viel höhere Aspektverhältnisse als bislang erzielbar. Dabei galt nach herkömmlicher Technik der Grundsatz, dass je größer ein Aspektverhältnis und je kleiner die absolute Größe einer Mikrostruktur, desto schwieriger die Fertigung.

Ein weiterer Vorteil des erfindungsgemäßen Verfahrens ist, dass so keine teuren, mikrostrukturierten Formeinsätze zur Herstellung der Mikrostruktur mehr benötigt werden. Solche Formeinsätze (Negativformen, beispielsweise für Mikrokanäle) sind extrem aufwändig zu fräsen und aus sehr teuren Werkstoffen, bspw. NiP. In den Formeinsätzen ist dann der beispielsweise zu erzeugende Mikrokanal folglich als erhabene Negativform vorhanden und insbesondere bei einem großen Aspektverhältnis extrem leicht zu beschädigen. Des Weiteren stellt das erfindungsgemäße Verfahren auch eine bessere Möglichkeit dar, durchgängige Mikrospalte zu erzeugen.

Gemäß einer Weiterbildung der Erfindung ist vorgesehen, dass das zweite Element während seiner Volumenverringerung zumindest bereichsweise auf einen Körper aufgeschrumpft wird.

Durch diese Maßnahme ist es somit sehr gut möglich, durch konstruktive Maßnahmen den vornehmlichen Bereich der Volumenverringerung bzw. dessen örtliche Ausdehnung zu bestimmen. Dabei kann der Körper beispielsweise einstückiger Bestandteil des ersten Elementes sein. Er kann aber auch als gesondertes Teil mit dem ersten Element verbunden sein.

Als Verfahren zur Herstellung des ersten und/oder des zweiten Elementes bietet sich vorteilhaft das Spritzgussverfahren an. Dieses Verfahren ist in seinen Parametern bereits sehr gut beherrschbar und auch in der Mikrotechnik gut bewährt. Dennoch sind durchaus auch andere Verfahren denkbar, insbesondere für die Herstellung des ersten Elementes, wie z. B. Prägeverfahren.

Eine weitere Ausgestaltung des Erfindungsgedankens sieht vor, dass die Werkstoffe der Elemente zumindest hinsichtlich ihres Schwindungskoeffizienten unterschiedlich sind. Dabei wird der Werkstoff des zweiten Elementes in der Regel einen größeren Schwindungskoeffizienten als der des Werkstoffs vom zweiten Element aufzuweisen haben. Über diese Werkstoffeigenschaft lässt sich der gewünschte Effekt am leichtesten erzielen. Die Werkstoffe der Elemente können aber auch noch hinsichtlich weiterer Eigenschaften voneinander abweichen, beispielsweise hinsichtlich ihres Schmelzpunktes oder ihrer Eigenschaften, sich mit dem Werkstoff des anderen Elementes zu verbinden. Vereinfacht wird das Verfahren dadurch, dass für die Elemente Werkstoffe gewählt werden, die nicht dazu neigen, sich miteinander zu verbinden. In diesem Falle braucht nach der Erzeugung des ersten Elementes nicht unbedingt bis zur Abkühlung von dessen Werkstoff auf eine unkritische Temperatur abgewartet zu werden. Das Zusammenführen der Werkstoffe der beiden Elemente bei einer solchen kritischen Temperatur könnte ansonsten die Gefahr einer unerwünschten Verbindung der Werkstoffe mit sich bringen.
Es bietet sich für das erfindungsgemäße Verfahren an, im Spritzgussverfahren gut verarbeitbare Kunststoffe auszuwählen, wobei das Verfahren den großen Vorteil bietet, dass man bei der Wahl der Werkstoffpaarung große Auswahl hat.

Gemäß einer Weiterbildung der Erfindung ist vorgesehen, dass im ersten Verfahrensschritt das erste Element mit mehreren Durchgangsöffnungen und/oder Kanälen hergestellt wird und im zweiten Verfahrensschritt die Durchgangsöffnungen und/oder Kanäle mit dem Werkstoff des zweiten Elementes gefüllt werden. Die Durchgangsöffnungen und/oder Kanäle können somit bei der anschließend erzeugten Volumenverringerung bzw. Schwindung des Werkstoffs des zweiten Elementes gezielt als Ausgangspunkt zur Erzeugung von Mikrostrukturen, bspw. Mikrospalten genutzt werden.

Der Erfindung liegt auch die Aufgabe zugrunde, ein mikrofluidisches Bauteil, aufweisend wenigstens einen zumindest bereichsweise lichten Zwischenraum zwischen einem ersten Element und einem zweiten Element bereitzustellen, welches zumindest mit dem erfindungsgemäßen Verfahren sehr gut herstellbar ist.

Diese Aufgabe wird mit den kennzeichnenden Merkmalen von Patentanspruch 6 gelöst. Die Unteransprüche stellen wiederum vorteilhafte Ausgestaltungen dar.
Erfindungsgemäß ist vorgesehen, dass das erste Element wenigstens mit einem Körper verbunden ist, welcher mit dem zweiten Element eine kraft- und/oder formschlüssige Verbindung bildet. Es wird somit gezielt ein mit dem ersten Element verbundener Körper bereitgestellt, auf welcher das zweite Element aufschrumpfen kann und somit mit diesem eine kraft- und/oder formschlüssige Verbindung eingeht. Dabei ist es zur Vereinfachung des Verfahrens bzw. zur Reduzierung der Teilevielfalt zweckmäßig, wenn der Körper einstückig mit dem ersten Element verbunden ist.

Hierbei sind unterschiedliche Formen für den Körper denkbar. Beispielsweise ist es vorteilhaft, wenn der Körper im Grundriss in etwa rechtwinklig zueinander stehende Seiten aufweist oder die Form eines Vielecks. Mit den so bestehenden Kanten des Körpers kann der Werkstoff des zweiten Elementes sehr leicht eine entsprechende kraft- und/oder formschlüssige Verbindung eingehen.

Dabei ist vorteilhaft, das erste Element derart zu gestalten, dass dieses wenigstens eine Durchgangsöffnung aufweist und diese von einem Teil des zweiten Elements nicht ganz ausgefüllt ist, derart, dass zumindest in Teilen des Randbereichs der Durchgangsöffnung der lichte Zwischenraum vorhanden ist. Dies lässt sich mit dem erfindungsgemäßen Verfahren leicht realisieren. Wird nämlich die Durchgangsöffnung durch den Werkstoff des zweiten Elementes zunächst vollständig ausgefüllt, so bildet sich -bedingt durch die veranlasste Volumenverringerung (Schwindung) dieses Werkstoffs- an mehreren Seiten der Durchgangsöffnung (fast umlaufend), und zwar an deren Randbereich, der lichte Zwischenraum in Form eines durchgehenden Spaltes aus. Dies führt zu einem Mehr an verfügbarem (nutzbarem) lichten Zwischenraum quer zum Durchgang der Durchgangsöffnung, was durchaus wünschenswert sein kann. Dieser Effekt wird insbesondere dann noch vergrößert, wenn das erste Element eine Vielzahl von Durchgangsöffnungen aufweist, wodurch sich eine Gitterstruktur ergibt.

Wenn zweckmäßigerweise die Gitterstruktur mit rinnenförmigen Vertiefungen versehen ist, so können diese Vertiefungen dazu genutzt werden, dass sich der Werkstoff des zweiten Elementes (insbesondere bei Verwendung des Spritzgussverfahrens) leicht innerhalb der Gitterstruktur ausbreiten bzw. diese befüllen kann.

Zur Erzeugung einer 3D-Zerstäuberdüse kann die Durchgangsöffnung des ersten Elementes bspw. kegelstumpfförmig ausgebildet sein. Wird diese dann mit dem Werkstoff des zweiten Elementes ausgefüllt und dieser einer Volumenverringerung unterzogen, so entsteht die bekannte Kanalstruktur einer solchen Zerstäuberdüse, wobei sich der entstandene Mikrokanal mantelförmig um das zweite Element erstreckt.

Vorteilhaft kann auch vorgesehen sein, dass die Durchgangsöffnungen zusammen mit dem zweiten Element eine Vielzahl von lichten Zwischenräumen bilden und die lichten Zwischenräume Abzweigkanäle zu einem Hauptkanal sind. So könnte in dem Hauptkanal beispielsweise eine Probelösung (z.B. Blut) transportiert werden und die lichten Zwischenräume könnten als Abzweigkanäle für zellverarmtes Blutplasma dienen. Durch die aufgrund der Struktur mögliche Vielzahl der Abzweigkanäle und damit der erhöhten "Abzweig-Fläche" ist eine deutliche Erhöhung des Flüssigkeitsdurchsatzes beispielsweise hin zu Messstellen innerhalb beispielsweise eines Biosensors und damit eine deutliche Erhöhung der Messgeschwindigkeit möglich.

Weitere Vorteile und Ausgestaltungen der Erfindung werden anhand von Ausführungsbeispielen deutlich, was mit Hilfe der beiliegenden Figuren näher erläutert werden soll. Die Figuren sind dabei nicht maßstabsgerecht und stark vergrößert dargestellt. Dabei bedeuten
- Fig. 1: die perspektivische Detailansicht eines bevorzugten Ausführungsbeispiels eines mit dem erfindungsgemäßen Verfahren erzeugten lichten Zwischenraums im Bereich einer Gitterstruktur des ersten Elementes vom mikrofluidischen Bauteil, wobei auch das zweite Element sichtbar ist,
- Fig. 2: eine perspektivische Darstellung der gesamten Gitterstruktur des bereits erzeugten ersten Elementes, wobei der Werkstoff des zweiten Elementes dem ersten Element noch nicht zugeführt wurde,
- Fig. 3: eine Detailansicht aus der Gitterstruktur des ersten Elementes gemäß Fig. 2,
- Fig. 4: eine perspektivische Darstellung der Gitterstruktur des ersten Elementes, wobei diese bereits mit dem Werkstoff des zweiten Elementes gefüllt ist,
- Fig. 5: eine Detaildarstellung eines Bereichs aus der Ansicht gemäß Fig. 4,
- Fig. 6: eine perspektivische Teil(schnitt)darstellung eines zweiten, mit dem erfindungsgemäßen Verfahren erzeugten mikrofluidischen Bauteils,
- Fig. 7: eine Draufsicht auf die Teilansicht gemäß Fig. 6,
- Fig. 8: eine perspektivische Teil(schnitt)darstellung eines weiteren mit dem erfindungsgemäßen Verfahren hergestellten mikrofluidischen Bauteils,
- Fig. 9: eine äußerst prinziphafte Darstellung der Strömung einer Probelösung, wie sie im Bereich der Gitterstruktur gemäß den Fig. 1 bis 5 auftreten kann,
- Fig. 10: eine Prinzipdarstellung eines Beispiels für eine herkömmliche Form zur Herstellung einer mikrofluidischen Struktur und
- Fig. 11: ein Teil einer mittels eines herkömmlichen Abformverfahrens hergestellten mikrofluidischen Struktur.

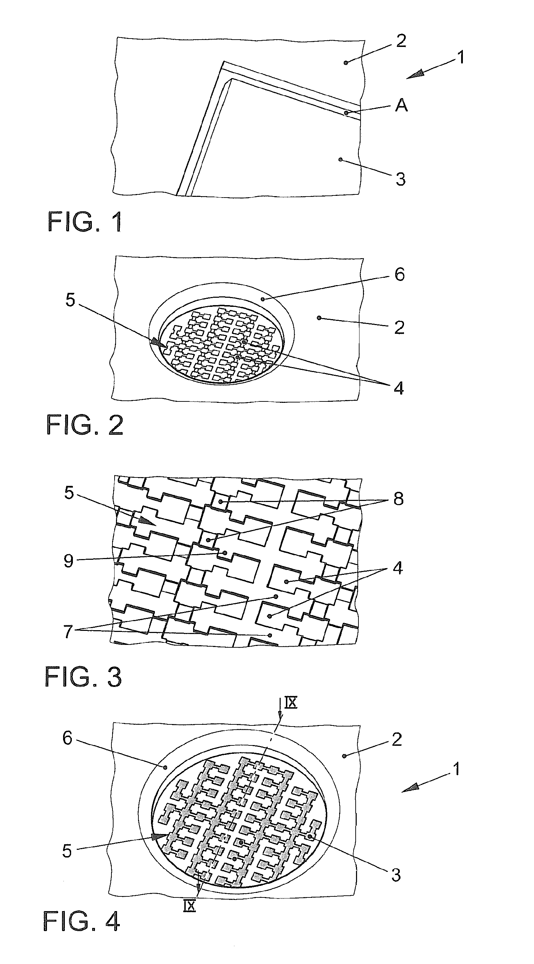

Zunächst wird auf die Fig. 1 bis 5 Bezug genommen.

So zeigt die Fig. 1 einen vergrößerten Teilausschnitt eines mikrofluidischen Bauteils 1, welches zumindest aus einem ersten Element 2 und aus einem zweiten Element 3 besteht. Das erste Element 2 und das zweite Element 3 sind beide aus Kunststoff, wobei diese jedoch unterschiedliche Schwindungskoeffizienten aufweisen. Das dargestellte mikrofluidische Bauteil 1 wurde durch Spritzguss hergestellt, wie später noch erläutert wird. Dabei wurde zunächst das erste Element 2 im Spritzgussverfahren hergestellt und anschließend der Werkstoff des zweiten Elementes 3 dem ersten Element ebenfalls im Spritzgussverfahren zugeführt. Nach anschließender (in diesem Fall durch Abkühlung) herbeigeführter Volumenverringerung (Schwindung) des Elementes 3 bildete sich ein lichter Zwischenraum A zwischen dem ersten Element 2 und dem zweiten Element 3 aus. Dieser lichte Zwischenraum A hat die Form eines Mikrospaltes. Der gezeigte Strukturausschnitt ist Bestandteil einer größeren Struktur (vergleiche Fig. 4).

Dabei wurde zunächst das erste Element 2 des mikrofluidischen Bauteils 1 mit einer Gitterstruktur 5 durch Spritzgießen hergestellt. Die Gitterstruktur 5 weist Durchgangsöffnungen 4 auf und befindet sich im Bereich einer kreisrunden Vertiefung 6 (vgl. Fig. 2).

In Fig. 3, welche einen vergrößerten Teilausschnitt aus der Gitterstruktur 5 zeigt, ist ersichtlich, dass die Durchgangsöffnungen 4 im Grundriss in etwa rechteckige, insbesondere quadratische Form aufweisen. Dabei sind die Durchgangsöffnungen 4 durch flache Stege 7 begrenzt. Ferner ist erkennbar, dass manche Stege 7 mit rinnenartigen Vertiefungen 8 versehen sind. Wird die Gitterstruktur 5 mit dem Werkstoff des zweiten Elementes 3 befüllt (vergleiche Fig. 4), so dienen die rinnenartigen Vertiefungen 8 dazu, dass sich der Werkstoff des zweiten Elementes 3 leichter innerhalb der Durchgangsöffnungen 4 der Gitterstruktur 5 verteilen bzw. diese (4) befüllen kann. Es sei angemerkt, dass der Übersichtlichkeit halber natürlich die zur Herstellung bzw. Befüllung verwendeten Spritzgussformen nicht näher dargestellt sind.

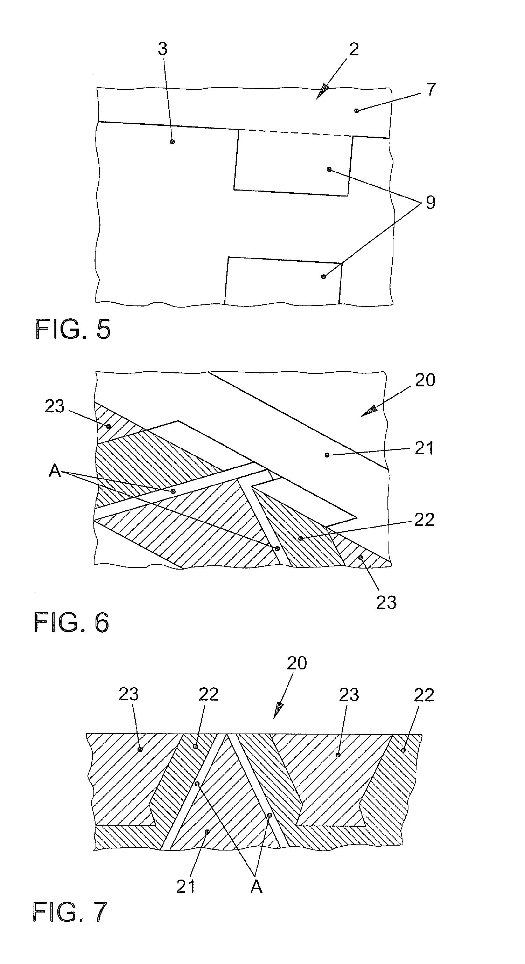

In Fig. 5 ist wiederum eine Detailansicht aus der Gitterstruktur 5 gemäß Fig. 4 ersichtlich. Es ist insbesondere erkennbar, dass an die Stege 7 des zweiten Elementes 2 in etwa rechteckförmige Körper 9 angeformt sind. Dabei soll die in Fig. 5 ersichtliche gestrichelte Linie nur zur besseren Abgrenzung des angeformten Körpers 9 vom Steg 7 dienen. Die angeformten Körper 9 sind insbesondere gegenüberliegend an die Stege 7 angeformt, so dass sich in der Draufsicht ein in etwa hantelförmiges Aussehen zweier nebeneinander liegender Durchgangsöffnungen 4 ergibt. Nach Zuführung des Werkstoffs vom zweiten Element 3 zum ersten Element 2 dienen die Körper 9 sozusagen als Kerne, auf die während des Schwindungsprozesses des Werkstoffs vom Element 3 dieser aufschrumpfen kann und somit das zweite Element 3 einen Kraft-und/oder Formschluss mit dem Körper 9 eingeht. Der zugeführte Werkstoff vom zweiten Element 3 füllt also zunächst die Durchgangsöffnungen 4 vollkommen aus. Aufgrund seiner Volumenverringerung (Schwindung) bilden sich jedoch an mehreren Seiten der Durchgangsöffnungen 4 (fast umlaufend), und zwar an deren Randbereichen, Spalte A aus (vgl. Fig.1). Die Gesamt-Durchgangsfläche quer zum Durchgang der Durchgangsöffnungen 4 kann somit deutlich erhöht werden.

Kurz noch einmal zusammengefasst, wird also zunächst das erste Element (oder auch Bauteil) 2 des mikrofluidischen Bauteils 1, insbesondere dessen Gitterstruktur 5, mittels Spritzgießen hergestellt (Fig. 2). In einem nächsten Verfahrensschritt wird die Gitterstruktur 5 mit dem Werkstoff des zweiten Elementes 3 ebenfalls im Spritzgussverfahren ausgefüllt (vergleiche Fig. 4 und 5) und in einem dritten Verfahrensschritt das zweite Element 3 bzw. dessen Werkstoff einer Volumenverringerung (Schwindung) unterzogen (beispielsweise durch Abkühlung). Während der Schwindung schrumpft der Werkstoff des zweiten Elementes 3 auf die Körper 9 der Gitterstruktur 5 auf und es entstehen die gewünschten lichten Zwischenräume A, im vorliegenden Fall in Form von Mikrospalten (vergleiche Fig. 1). Vereinfacht gesagt wird also die Schwindung des Werkstoffs vom zweiten Element 3 gezielt zur Herstellung der lichten Zwischenräume A genutzt bzw. verwendet. Dabei kann die genaue Einstellung der Verfahrensparameter (beispielsweise Einstellung des Spritzdrucks, des Nachdrucks, der Verweildauer in der/den Gießformen sowie die Materialauswahl und -paarung) dem Fachmann überlassen werden. Das Gleiche gilt für die geometrische Ausgestaltung der Körper 9, die - abweichend von der in Fig. 3 bzw. 5 ersichtlichen Form beispielsweise auch bereichsweise kreisbogenartig ausgeführt sein können. Bevorzugtermaßen sollten als Werkstoffe für die Elemente 2 und 3 allerdings solche Werkstoffe ausgewählt werden, die keine stoffschlüssige Verbindung untereinander eingehen.

Im dargestellten Ausführungsbeispiel haben die in Fig. 3 ersichtlichen Durchgangsöffnungen 4 beispielsweise einen Öffnungsquerschnitt von etwa 1 mm². Das Schwindmaß des ausgewählten Werkstoffes des zweiten Elementes 3 beträgt ca. 0,1 bis 0,2 % seines Nennvolumens.

In Fig. 6 ist nunmehr noch ein zweites mikrofluidisches Bauteil 20 dargestellt, welches ebenfalls mit dem erfindungsgemäßen Verfahren herstellbar ist. Das Bauteil 20 besteht ebenfalls aus einem ersten Element 21 und einem zweiten Element 22, wobei sich der Werkstoff des ersten Elementes 21 von dem des zweiten Elementes 22 ebenfalls zumindest hinsichtlich einer Werkstoffeigenschaft unterscheidet. Auch hier wurde das erste Element 21 im Spritzguss hergestellt und anschließend der Werkstoff des zweiten Elementes 22 durch Spritzguss in das erste Element 21 (in dort bereits vorhandene Kanäle) hineingebracht. Nachdem das zweite Element 22 einer Schwindung ausgesetzt wurde, schrumpfte dieses auf einen extra dafür ausgebildeten, einstückig mit dem ersten Element 21 verbundenen Körper 23 auf. Dadurch entstanden gewünschte lichte Zwischenräume A (Spalte) zwischen dem ersten Element 21 und dem zweiten Element 22. In Fig. 7 ist dies noch einmal aus einer anderen Perspektive ersichtlich. Zusätzlich ist hier erkennbar, dass die Körper 23 in der Draufsicht die Form eines Vielecks aufweisen, was zu einem guten Formschluss des zweiten Elements 22 um diese Körper 23 führt. Die dargestellte Struktur ist bei Zerstäuberdüsen einsetzbar.

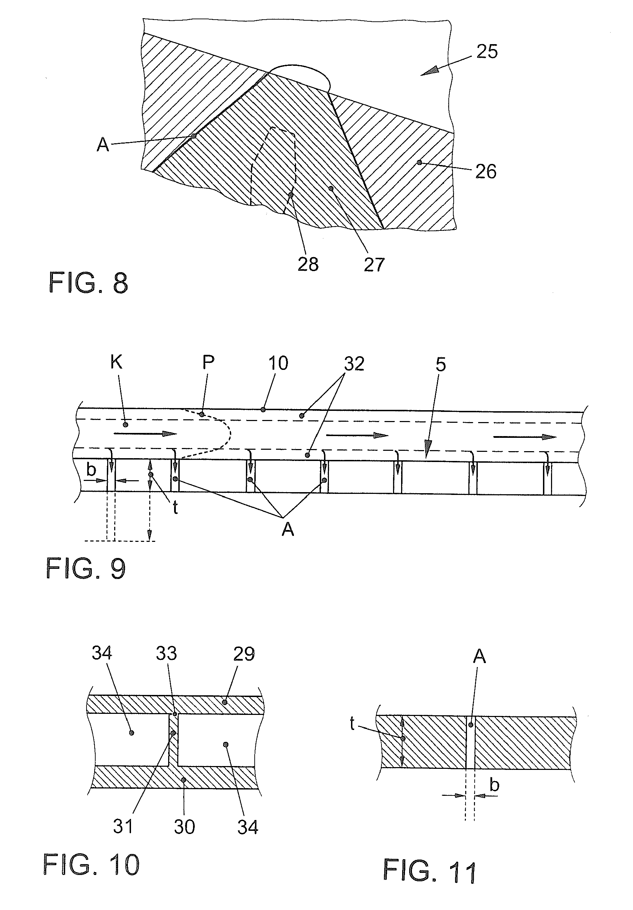

In Fig. 8 ist noch ein weiteres bevorzugtes Anwendungsbeispiel des erfindungsgemäßen Verfahrens dargestellt. Hierbei wurde zunächst ein erstes Element 26 eines mikrofluidischen Bauteils 25 mittels Spritzguss hergestellt, wobei das erste Element 26 eine kegelstumpfförmige Durchgangsöffnung aufwies. In diese kegelstumpfförmige Öffnung wurde in einem zweiten Spritzgießvorgang der Werkstoff eines zweiten Elementes 27 zugeführt und dieser anschließend einer Volumenverringerung (Schwindung) unterzogen. Während der Schwindung konnte der Werkstoff des zweiten Elementes 27 um einen zuvor mit dem ersten Element 26 verbundenen Körper 28 (gestrichelt angedeutet) schrumpfen, wodurch einerseits eine sichere Fixierung des zweiten Elementes 27 gewährleistet war und andererseits ein mantelförmig umlaufender, lichter Zwischenraum A entstand. Eine derartige mikrofluidische Struktur ist bei 3D-Zerstäuberdüsen einsetzbar.

Nunmehr wird auf Fig. 9 Bezug genommen. Darin ist prinziphaft dargestellt, wie die in den Fig. 1 bis 5 dargestellte Gitterstruktur mit den erzeugten spaltförmigen Zwischenräumen A, welche Bestandteil eines nicht weiter dargestellten Biosensors ist, zur Verbesserung der Messgeschwindigkeit bzw. Effizienz des Biosensors beitragen kann. So ist über der Gitterstruktur 5 eine Abdeckung 10 angeordnet, so dass ein Hauptkanal K gebildet wird. In der Gitterstruktur 5 sind die quer zum Hauptkanal K verlaufenden spaltartigen Zwischenräume A ersichtlich, wobei jeder Zwischenraum A eine bestimmte Breite b und eine bestimmte Tiefe t aufweist, durch die ein bestimmtes Aspektverhältnis (t/b) definiert ist. Die Darstellung in Fig. 9 stellt somit eine äußerst prinziphafte Schnittdarstellung gemäß Schnittverlauf IX aus Fig. 4 (allerdings nach einem bereits erfolgten Schwindungsprozess wie in Fig. 1) dar, wobei die in Fig. 9 angedeutete Abdeckung 10 der besseren Darstellbarkeit halber in Fig. 4 nicht dargestellt wurde.
Durch die in Fig. 9 dargestellte Struktur ist es nun möglich, dass die Gitterstruktur 5 tangential von einer Probelösung P (beispielsweise Blut) überströmt wird. Im Randbereich des Strömungsprofils der Probelösung P ergibt sich ein zellarmer Bereich 32. Durch die Vielzahl der mit diesem Randbereich 32 in Kontakt geratenden Abzweigkanäle A kann nun das in der Probelösung P befindliche, zellarme Blutplasma vergleichsweise schnell abgeführt und zu einem gewünschten Messort hin transportiert werden, was zu einer deutlichen Verbesserung der Effizienz des Biosensors führt. Die Abführung des zellarmen Blutplasmas der Probelösung P in die Abzweigkanäle A (vergleiche kleine Pfeile) kann einerseits durch die Kapillarität der Kanäle A realisiert werden, andererseits ist es auch denkbar, die dargestellte Separation durch eine aktiv (also gerätetechnisch) angelegte Druckdifferenz zu realisieren (nicht näher dargestellt), was unter Umständen erwünscht sein kann.
Hierbei ist anzumerken, dass allerdings die mit der klassischen Abformung realisierbaren Aspektverhältnisse bei Nutzung von hydrophilen, also Wasser anziehenden Stoffen nur sehr geringe Druckdifferenzen (beispielsweise 10 mbar) mit sich bringen. Gerätetechnisch sind derartige Druckdifferenzen kaum umsetzbar. Wie anfangs beschrieben, können mit dem erfindungsgemäßen Verfahren jedoch Aspektverhältnisse der Zwischenräume A hergestellt werden, die deutlich über denen mittels der klassischen Abformtechnik realisierbaren Aspektverhältnissen liegen. In der Fig. 9 ist gestrichelt angedeutet, dass mit dem erfindungsgemäßen Verfahren das Aspektverhältnis der Zwischenräume A (insbesondere Tiefe t) natürlich auch noch größer realisiert werden kann. Demzufolge ergibt sich ein größerer Widerstand für den abgezweigten Teil der Probelösung P, um durch die Zwischenräume (Spalte) A zu gelangen (Durchflusswiderstand). Wählt man zusätzlich als Werkstoff für das zweite Element 3 bzw., auch für das erste Element 2 noch einen hydrophoben (also Wasser abstoßenden) Kunststoff aus, so wird der Durchflusswiderstand noch größer, mithin ist eine noch deutlich größerer Druckdifferenz aufzubringen. Eine höhere Druckdifferenz ist gerätetechnisch aber leichter umzusetzen.

Die durch das erfindungsgemäße Verfahren vergleichsweise leicht herstellbaren, großen Aspektverhältnisse führen aber auch (insbesondere in Verbindung mit einer tangentialen Anströmung (vergleiche Fig. 9) dazu, dass beispielsweise bei Blut als Probelösung P die Blutzellen (insbesondere rote Blutkörperchen und Thrombozyten) vergleichsweise lange Zeit benötigen, um in bzw. durch die Abzweigkanäle A durchzudringen. In dieser Zeit sind zur Messung erforderliche Analyten, die sich auch im zellarmen Randbereich 32 befinden, bereits von der Hauptströmung separiert und zum Messort gelangt. Bei einem herkömmlichen Filter (der im vorliegenden Ausführungsbeispiel nach den Fig. 1 bis 5 durch die erfindungsgemäß hergestellte Gitterstruktur 5 mit Spalten A quasi ersetzt wurde) ist eine tangentiale Anströmung nicht möglich. Zudem ist man bei herkömmlichen Filtern in der Wahl des Werkstoffs beschränkt. Wird eine Probelösung auf einen herkömmlichen Filter gegeben, so breitet diese sich sofort aus und dringt in den Filter ein. Die Folge ist eine schnelle Verstopfung des Filters mit Blutzellen (Filterkuchenbildung), was im Extremfall dazu führt, dass nicht ausreichend oder gar kein Filtrat zum Messort gelangt.

Abschließend zeigen Fig. 10 und 11 prinziphaft das Beispiel einer herkömmlichen Abformung zur Herstellung einer Mikrostruktur, insbesondere zur Herstellung eines durchgehenden Spaltes. Dabei ist in Fig. 10 ein Form-Oberteil 29 ersichtlich, welches auf einem Form-Unterteil 30 aufliegt. Das Form-Oberteil 29 und das Form-Unterteil 30 sind durch einen stegartigen Formkern 31, welcher einstückig mit dem Form-Unterteil 30 verbunden ist, beabstandet. Hierdurch entsteht ein Hohlraum 34, der beispielsweise im Spritzgussverfahren mittels einer Formmasse (nicht dargestellt) befüllbar ist. Es ist ohne weiteres nachvollziehbar, dass mit steigendem Aspektverhältnis des stegartigen Formkerns 31 der Aufwand zum "Freifräsen" des Formkerns 31 ansteigt und auch die Gefahr einer Beschädigung (Abnutzung) des Formteils 31 mit jedem "Schuss" an Formmasse ansteigt. Beabsichtigt man darüber hinaus, einen durchgehenden Zwischenraum (Spalt) A herzustellen, wie er in Fig. 11 nach abgeformten Zustand gezeigt ist, so ist es sehr schwierig, in einem kritischen Übergangsbereich 33 die dazu erforderliche Dichtigkeit sicherzustellen. Diese Schwierigkeiten steigen mit steigendem Aspektverhältnis für das herkömmliche Abformverfahren spürbar an.

Mit dem erfindungsgemäßen Verfahren können die genannten Schwierigkeiten umgangen werden. Es sind also erhebliche herstellungstechnische Vorteile realisierbar.

### Bezugszeichenliste

- 1: Mikrofluidisches Bauteil
- 2: erstes Element des mikrofluidischen Bauteils
- 3: zweites Element des mikrofluidischen Bauteils
- 4: Durchgangsöffnungen
- 5: Gitterstruktur
- 6: kreisrunde Vertiefung
- 7: Stege
- 8: rinnenartige Vertiefungen
- 9: an die Stege 7 des ersten Elementes 2 angeformter Körper
- 10: Abdeckung
- 20: Mikrofluidisches Bauteil
- 21: erstes Element des mikrofluidischen Bauteils
- 22: zweites Element des mikrofluidischen Bauteils
- 23: an das erste Elementes 21 angeformter Körper
- 25: Mikrofluidisches Bauteil
- 26: erstes Element des mikrofluidischen Bauteils
- 27: zweites Element des mikrofluidischen Bauteils
- 28: mit dem ersten Element 26 verbundener Körper
- 29: Form-Oberteil
- 30: Form-Unterteil
- 31: stegartiger Formkern
- 32: zellarmer Randbereich im Strömungsprofil der Probelösung
- 33: kritischer Übergangsbereich vom stegartigen Formkern 31 zum Form-Oberteil 29
- 34: Hohlraum
- A: lichter Zwischenraum
- b: Breite des Zwischenraums A
- K: Hauptkanal
- P: Probelösung
- t: Tiefe des Zwischenraums A

## Patentansprüche

1. Verfahren zur Erzeugung eines zumindest bereichsweise lichten Zwischenraums (A) zwischen wenigstens einem ersten Element (2,21,26) und wenigstens einem zweiten Element (3,22,27) eines mikrofluidischen Bauteils (1,20,25), wobei die Werkstoffe der Elemente (2,21,26 bzw. 3,22,27) zumindest hinsichtlich einer ihrer Eigenschaften unterschiedlich sind, wobei in einem ersten Verfahrensschritt das erste Element (2,21,26) hergestellt und in einem zweiten Verfahrensschritt der Werkstoff des zweiten Elementes (3,22,27) dem ersten Element (2,21,26) zugeführt wird und wobei in einem dritten Verfahrensschritt das zweite Element (3,22,27) zumindest bereichsweise einer Volumenverringerung unterzogen wird, derart, dass der zumindest bereichsweise lichte Zwischenraum (A) entsteht.

2. Verfahren nach Anspruch 1, **dadurch gekennzeichnet, dass** das zweite Element (3,22,27) während seiner Volumenverringerung zumindest bereichsweise auf einen Körper (9,23,28) aufgeschrumpft wird.

3. Verfahren nach wenigstens einem der vorhergehenden Ansprüche, **dadurch gekennzeichnet, dass** das erste Element (2,21,26) und das zweite Element (3,22,27) im Spritzgussverfahren hergestellt werden.

4. Verfahren nach wenigstens einem der vorhergehenden Ansprüche, **dadurch gekennzeichnet, dass** die Werkstoffe der Elemente (2,21,26 bzw. 3,22,27) zumindest hinsichtlich ihres Schwindungskoeffizienten unterschiedlich sind.

5. Verfahren nach wenigstens einem der vorhergehenden Ansprüche, **dadurch gekennzeichnet, dass** im ersten Verfahrensschritt das erste Element (2,21,26) mit mehreren Durchgangsöffnungen (4) und/oder Kanälen hergestellt wird und im zweiten Verfahrensschritt die Durchgangsöffnungen (4) und/oder Kanäle mit dem Werkstoff des zweiten Elementes (3,22,27) befüllt werden.

6. Mikrofluidisches Bauteil (1,20,25), welches zumindest nach einem Verfahren gemäß wenigstens einem der vorhergehenden Ansprüche 1 bis 5 herstellbar ist, aufweisend wenigstens einen zumindest bereichsweise lichten Zwischenraum (A) zwischen einem ersten Element (2,21,26) und einem zweiten Element (3,22,27), **dadurch gekennzeichnet, dass** das erste Element (2,21,26) wenigstens mit einem Körper (9,23,28) verbunden ist, welcher mit dem zweiten Element (3,22,27) eine kraft- und/oder formschlüssige Verbindung bildet.

7. Mikrofluidisches Bauteil (1,20) nach Anspruch 6, **dadurch gekennzeichnet, dass** der Körper (9,23) einstückig mit dem ersten Element (2,21,26) verbunden ist.

8. Mikrofluidisches Bauteil (1,20) nach wenigstens einem der Ansprüche 6 bis 7, **dadurch gekennzeichnet, dass** der Körper (9,23) im Grundriss in etwa rechtwinklig zueinander stehen Seiten oder die Form eines Vielecks (23) aufweist.

9. Mikrofluidisches Bauteil (1,20,25) nach wenigstens einem der Ansprüche 6 bis 8, **dadurch gekennzeichnet, dass** das erste Element (2,21,26) wenigstens eine Durchgangsöffnung (4) aufweist, und diese von einem Teil des zweiten Elements (3,22,27) nicht ganz ausgefüllt ist, derart, dass zumindest in Teilen des Randbereichs der Durchgangsöffnung (4) der lichte Zwischenraum (A) vorhanden ist.

10. Mikrofluidisches Bauteil (1) nach wenigstens einem der Ansprüche 6 bis 10, **dadurch gekennzeichnet, dass** das erste Element (2) eine Vielzahl von Durchgangsöffnungen (4) aufweist, wodurch sich eine Gitterstruktur (5) ergibt.

11. Mikrofluidisches Bauteil (1) nach wenigstens einem der Ansprüche 6 bis 11, **dadurch gekennzeichnet, dass** die Gitterstruktur (5) mit rinnenförmigen Vertiefungen (8) versehen ist.

12. Mikrofluidisches Bauteil (20) nach wenigstens einem der Ansprüche 6 bis 11, **dadurch gekennzeichnet, dass** die Durchgangsöffnung kegelstumpfförmig ausgebildet ist.

13. Mikrofluidisches Bauteil (1) nach wenigstens einem der Ansprüche 6 bis 12, **dadurch gekennzeichnet, dass** die Durchgangsöffnungen (4) zusammen mit dem zweiten Element (3) eine Vielzahl von lichten Zwischenräumen (A) bilden und die lichten Zwischenräume (A) Abzweigkanäle zu einem Hauptkanal (A) sind.

## Geänderte Patentansprüche

### Geänderte Patentansprüche gemäss Regel 137(2) EPÜ.

**1.** Verfahren zur Erzeugung eines zumindest bereichsweise lichten Zwischenraums (A) zwischen wenigstens einem ersten Element (2,21,26) und wenigstens einem zweiten Element (3,22,27) eines mikrofluidischen Bauteils (1,20,25), wobei die Werkstoffe der Elemente (2,21,26 bzw. 3,22,27) zumindest hinsichtlich einer ihrer Eigenschaften unterschiedlich sind, wobei in einem ersten Verfahrensschritt das erste Element (2,21,26) hergestellt und in einem zweiten Verfahrensschritt der Werkstoff des zweiten Elementes (3,22,27) dem ersten Element (2,21,26) zugeführt wird und wobei in einem dritten Verfahrensschritt das zweite Element (3,22,27) zumindest bereichsweise einer Volumenverringerung unterzogen wird, derart, dass der zumindest bereichsweise lichte Zwischenraum (A) entsteht, **dadurch gekennzeichnet, dass** das zweite Element (3,22,27) während seiner Volumenverringerung zumindest bereichsweise auf einen Körper (9,23,28) aufgeschrumpft wird.

**2.** Verfahren nach wenigstens einem der vorhergehenden Ansprüche, **dadurch gekennzeichnet, dass** das erste Element (2,21,26) und das zweite Element (3,22,27) im Spritzgussverfahren hergestellt werden.

**3.** Verfahren nach wenigstens einem der vorhergehenden Ansprüche, **dadurch gekennzeichnet, dass** die Werkstoffe der Elemente (2,21,26 bzw. 3,22,27) zumindest hinsichtlich ihres Schwindungskoeffizienten unterschiedlich sind.

**4.** Verfahren nach wenigstens einem der vorhergehenden Ansprüche, **dadurch gekennzeichnet, dass** im ersten Verfahrensschritt das erste Element (2,21,26) mit mehreren Durchgangsöffnungen (4) und/oder Kanälen hergestellt wird und im zweiten Verfahrensschritt die Durchgangsöffnungen (4) und/oder Kanäle mit dem Werkstoff des zweiten Elementes (3,22,27) befüllt werden.

**5.** Mikrofluidisches Bauteil (1,20,25), welches zumindest nach einem Verfahren gemäß wenigstens einem der vorhergehenden Ansprüche 1 bis 5 herstellbar ist, aufweisend wenigstens einen zumindest bereichsweise lichten Zwischenraum (A) zwischen einem ersten Element (2,21,26) und einem zweiten Element (3,22,27), **dadurch gekennzeichnet, dass** das erste Element (2,21,26) wenigstens mit einem Körper (9,23,28) verbunden ist, welcher mit dem zweiten Element (3,22,27) eine kraft- und/oder formschlüssige Verbindung bildet.

**6.** Mikrofluidisches Bauteil (1.20) nach Anspruch 6, **dadurch gekennzeichnet, dass** der Körper (9,23) einstückig mit dem ersten Element (2,21,26) verbunden ist.

**7.** Mikrofluidisches Bauteil (1,20) nach wenigstens einem der Ansprüche 6 bis 7, **dadurch gekennzeichnet, dass** der Körper (9,23) im Grundriss in etwa rechtwinklig zueinander stehen Seiten oder die Form eines Vielecks (23) aufweist.

**8.** Mikrofluidisches Bauteil (1,20,25) nach wenigstens einem der Ansprüche 6 bis 8, **dadurch gekennzeichnet, dass** das erste Element (2,21,26) wenigstens eine Durchgangsöffnung (4) aufweist, und diese von einem Teil des zweiten Elements (3,22,27) nicht ganz ausgefüllt ist, derart, dass zumindest in Teilen des Randbereichs der Durchgangsöffnung (4) der lichte Zwischenraum (A) vorhanden ist.

**9.** Mikrofluidisches Bauteil (1) nach wenigstens einem der Ansprüche 6 bis 10, **dadurch gekennzeichnet, dass** das erste Element (2) eine Vielzahl von Durchgangsöffnungen (4) aufweist, wodurch sich eine Gitterstruktur (5) ergibt.

**10.** Mikrofluidisches Bauteil (1) nach wenigstens einem der Ansprüche 6 bis 11, **dadurch gekennzeichnet, dass** die Gitterstruktur (5) mit rinnenförmigen Vertiefungen (8) versehen ist.

**11.** Mikrofluidisches Bauteil (20) nach wenigstens einem der Ansprüche 6 bis 11, **dadurch gekennzeichnet, dass** die Durchgangsöffnung kegelstumpfförmig ausgebildet ist.

**12.** Mikrofluidisches Bauteil (1) nach wenigstens einem der Ansprüche 6 bis 12, **dadurch gekennzeichnet, dass** die Durchgangsöffnungen (4) zusammen mit dem zweiten Element (3) eine Vielzahl von lichten Zwischenräumen (A) bilden und die lichten Zwischenräume (A) Abzweigkanäle zu einem Hauptkanal (A) sind.
